# EUROPÄISCHE PATENTSCHRIFT

(11) **EP 4 321 887 B1**
(45) Veröffentlichungstag und Bekanntmachung des Hinweises auf die Patenterteilung: **30.04.2025**
(21) Anmeldenummer: 22189767.1
(22) Anmeldetag: 10.08.2022
(51) Int. Cl.: G01R 33/34, G01R 33/36, G01R 33/28, G01R 33/3415

(54) **LOKALSPULE FÜR EIN MAGNETRESONANZTOMOGRAPHIEYSTEM, SOWIE EIN MAGNETRESONANZTOMOGRAPHIESYSTEM**
LOCAL COIL FOR MAGNETIC RESONANCE TOMOGRAPHY SYSTEM AND MAGNETIC RESONANCE TOMOGRAPHY SYSTEM
BOBINE LOCALE POUR SYSTÈME DE TOMOGRAPHIE PAR RÉSONANCE MAGNÉTIQUE, AINSI QUE SYSTÈME DE TOMOGRAPHIE PAR RÉSONANCE MAGNÉTIQUE

(43) Veröffentlichungstag der Anmeldung: 14.02.2024
(73) Patentinhaber: Siemens Healthineers AG, 91301 Forchheim (DE)
(72) Erfinder: Fackelmeier, Andreas, 91177 Thalmässing (DE); Huber, Klaus, 91090 Effeltrich (DE); Rehner, Robert, 91077 Neunkirchen am Brand (DE); Zink, Stephan, 90451 Nürnberg (DE)
(74) Vertreter: Siemens Healthineers Patent Attorneys

(56) Entgegenhaltungen:
- WO-A1-2005/052621
- DE-A1- 102007 007 623
- DE-A1- 102020 208 232
- US-A1- 2007 262 777
- US-A1- 2008 238 424

## Beschreibung

Die Erfindung betrifft eine Lokalspule (LC) für ein Magnetresonanztomographiesystem (MRT-System), die einen plattenartigen Lokalspulenköper mit einer Haupterstreckungsebene und eine Elektronikvorrichtung innerhalb des Lokalspulenkörpers aufweist, sowie ein zugehöriges MRT-System.

MRT-Systeme sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession, um diese Ausrichtung, anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Um das Signal-zu-Rauschverhältnis zu verbessern, und auch um durch Parallel-Abtastung die Bilderfassung zu beschleunigen, werden zunehmend möglichst viele Empfangsantennen in Form einer als Lokalspulenmatrix bezeichneten Antennenmatrix möglichst nahe am Körper des Patienten angeordnet, die in einer sogenannten Lokalspule (engl.: Local Coil, LC) angeordnet sind. Zur Übertragung der in der LC bzw. Lokalspulenmatrix empfangenen Signale wird üblicherweise eine Kabelverbindung verwendet. Dabei wirken die Kabel aber auch als Antennen während des Anregungspulses, sodass spezielle Sicherheitsmaßnahmen wie Mantelwellensperren vorgesehen werden müssen, um den Patienten nicht zu gefährden. Auch ist die Handhabung der Kabel umständlich.

Momentan wird daher über eine Drahtlosübertragung von Bild- und Steuersignalen zwischen dem MRT-System und der LC nachgedacht. Die hierzu verwendeten elektrischen Bauteile in der LC benötigen sehr viel mehr elektrische Leistung als die für die drahtgebunden LCs was in einer sehr viel höheren Wärmeentwicklung resultiert, die abgeführt werden muss. Die Druckschrift DE 10 2020 208232 A1 offenbart, dass bei einer drahtlosen Erzeugung von Magnetresonanzsignalen eine zusätzliche Erwärmung auftreten kann.

Für eine zukünftige drahtlose LC wird über verschiedenste digitale Verfahren nachgedacht, bei welchen digitale Bausteine, wie beispielsweise ADC, FPGAs und Transceiver ICs, verwendet werden. Hierbei entsteht jedoch ein punktueller Wärmehotspot, da die digitalen Bausteine nah aneinander platziert werden müssen, damit durch Störsignale von längeren digitalen Signal-/Bus-Leitungen der MR-Empfang der LC nicht gestört wird. Demgegenüber steht jedoch, dass bei medizinischen Geräten die Oberflächentemperatur von berührbaren Flächen 41°C nicht überschritten werden darf. Dies ist in entsprechenden Normen verpflichtend festgelegt. Eine geeignete Lösung für eine drahtlose LC, die die entsprechenden Normen erfüllen kann, gibt es jedoch nicht.

Die Druckschriften WO 2005/052621 A1 und US 2008/238424 A1 offenbaren Lokalspulen mit einem Substrat und einer Leiterplatte, auf dem bzw. der Elektronikmodule angeordnet sind.

Der Erfindung liegt somit die Aufgabe zugrunde, eine Lokalspule bereitzustellen, deren Oberfläche im Betrieb eine normgerechte Temperatur aufweist.

Die Aufgabe wird durch die Gegenstände der unabhängigen Patentansprüche gelöst. Vorteilhafte Weiterbildungen der Erfindung sind durch die abhängigen Patentansprüche, die folgende Beschreibung sowie die Figuren beschrieben.

Durch einen ersten Aspekt der Erfindung ist eine Lokalspule für ein Magnetresonanztomographiesystem bereitgestellt, die einen plattenartigen Lokalspulenkörper mit einer Haupterstreckungsebene und eine Elektronikvorrichtung innerhalb des Lokalspulenkörpers aufweist. Erfindungsgemäß weist die Lokalspule einen elektrisch nichtleitenden Wärmeleitkörper auf, der wärmeleitend mit der Elektronikvorrichtung verbunden und plattenartig innerhalb des Lokalspulenkörpers ausbildet ist, um Wärme der Elektronikvorrichtung in der Haupterstreckungsebene des Lokalspulenkörpers zu verteilen.

Insbesondere kann es sich bei der Lokalspule (LC) um eine drahtlose LC handelt. Darunter ist zu verstehen, dass die LC drahtlos mit einer externen Vorrichtung des MRT-Systems kommunizieren kann. Beispielsweise können über eine bidirektionale, drahtlose Kommunikationsverbindung zwischen der LC und der externen Vorrichtung Bildsignale und/oder Steuersignale übertragen werden. Insbesondere kann es sich dabei um eine digitale Kommunikationsverbindung handeln.

Die LC bzw. ein Körper der LC, hier als Lokalspulenkörper bezeichnet, ist plattenartig ausgebildet. Insbesondere bedeutet dies, dass eine Erstreckung senkrecht zu der virtuellen Haupterstreckungsebene wesentlich kleiner ist als Erstreckungen parallel zu der Haupterstreckungsebene. Der plattenartige Körper kann Erhebungen, Ausbauchungen oder dergleichen aufweisen, in der beispielsweise Komponenten der LC untergebracht sein können. Der Lokalspulenkörper, und damit auch die Haupterstreckungsebene, können gewölbt sein, sowie Rundungen, Wellen oder dergleichen aufweisen. Insbesondere kann die LC an eine Form von Gliedmaßen, Rumpf oder Kopf eines Menschen oder Tieres anpassbar sein.

Die Elektronikvorrichtung ist in einem Inneren des Lokalspulenkörpers angeordnet. Diese kann vorzugsweise lokal im Lokalspulenkörper konzentriert sein. Durch die lokale Konzentration der Elektronikvorrichtung kann im Betrieb Wärme entstehen, die zu einer hohen Temperatur führen kann.

Beispielsweise kann die Elektronikvorrichtung eine Leiterplatte aufweisen, auf der mehrere elektronische Bauteile befestigt und elektrisch verbunden sein können. Beispielsweise weist die Elektronikvorrichtung eine elektronische Kommunikationseinrichtung zur drahtlosen und digitalen Kommunikation mit der externen Vorrichtung auf. Des Weiteren kann die Elektronikvorrichtung hierzu einen Analog Digital Converter (ADC), integrierte Schaltkreise (IC), beispielsweise ein FPGA (Field Programmable Gate Array) oder ein Transceiver IC, oder dergleichen aufweisen. Die Elektronikvorrichtung kann darüber hinaus eine Steuereinheit, eine Recheneinheit, einen Energiespeicher oder dergleichen aufweisen.

Der Wärmeleitkörper ist ein elektrischer Nichtleiter bzw. ein elektrischer Isolator. Insbesondere kann es vorgesehen sein, dass der Wärmeleitkörper absolut unmagnetisch und nicht magnetisierbar ist. Vorzugsweise kann der Wärmeleitkörper aus einem wärmeleitfähigen Kunststoff bestehen, wobei das Material bzw. die Partikel, die in den Kunststoff eingebracht sind, elektrisch nichtleitend und unmagnetisch sind. Der Wärmeleitkörper kann starr oder verformbar ausgebildet sein.

Der Wärmeleitkörper ist wärmeleitend, insbesondere kontaktierend, mit der Elektronikvorrichtung verbunden, sodass vorzugsweise Wärme mittels Wärmeleitung von der Elektronikvorrichtung über den Wärmeleitkörper abgeführt werden kann. Dies hat zu Folge, dass eine Temperatur an der Oberfläche der Lokalspule in einem Bereich der Elektronikvorrichtung einen vorgegebenen Grenzwert nicht übersteigt.

Der Wärmeleitkörper ist plattartig innerhalb des plattenartigen Lokalspulenkörpers ausgebildet, vorzugsweise in der Haupterstreckungsebene des Lokalspulenkörpers. Insbesondere bedeutet dies, dass eine Erstreckung des Wärmeleitkörpers senkrecht zu der virtuellen Haupterstreckungsebene wesentlich kleiner ist als Erstreckungen parallel zu der Haupterstreckungsebene. Dadurch kann erreicht werden, dass die Wärme der Elektronikvorrichtung im Wesentlichen in der Haupterstreckungsebene des Lokalspulenkörpers verteilt wird. In der Folge kann die Temperatur der Oberfläche der Lokalspule, insbesondere einer Ober- und Unterseite der Lokalspule, im Bereich der Elektronikvorrichtung unterhalb eines vorgegebenen Grenzwertes gehalten werden.

Beispielsweise kann der Wärmeleitkörper innerhalb eines Abschnittes des Lokalspulenkörpers oder im Wesentlichen innerhalb des gesamten Lokalspulenkörpers ausgebildet sein.

Durch die Erfindung ergibt sich der Vorteil, dass eine Temperatur an der Oberfläche, im Speziellen im Bereich der Elektronikvorrichtung, die Grenztemperatur, beispielsweise 41 °C, im Betrieb nicht übersteigt. Vorteilhaft kann durch die Erfindung, im Speziellen durch die optimierte Form des Wärmeleitkörpers, die Wärme in der Haupterstreckungsebene so verteilt werden, sodass eine Temperaturverteilung an der Oberfläche der Lokalspule gleichmäßig ist.

Zu der Erfindung gehören auch Ausführungsformen, durch die sich zusätzliche Vorteile ergeben.

Eine Ausführungsform sieht vor, dass die Elektronikvorrichtung von dem Wärmeleitkörper umschlossen ist. Der Wärmeleitkörper kann die Elektronikvorrichtung vollständig umschließen. Unter umschlossen kann verstanden werden, dass der Wärmeleitkörper die Elektronikvorrichtung kontaktierend umgibt. Dies hat den Vorteil, dass die Wärme von der Elektronikvorrichtung lediglich in den Wärmeleitkörper geleitet werden kann. Somit kann die Wärme verbessert verteilt werden und nicht anderweitig an die Oberfläche dringen.

Eine Ausführungsform sieht vor, dass die Elektronikvorrichtung, in der Haupterstreckungsebene betrachtet, in einer Mitte des Wärmeleitkörpers angeordnet ist. Die Mitte kann insbesondere eine Fläche bzw. ein Raum um einen geometrischen Mittelpunkt des Wärmeleitkörpers in der Haupterstreckungsebene sein.

Eine Anordnung der Elektronikvorrichtung in der Erstreckung senkrecht zu der Haupterstreckungsebene ist durch die Anordnung in der Mitte nicht beschränkt. Vorzugsweise kann die Elektronikvorrichtung, senkrecht zu der Haupterstreckungsebene betrachtet, in einem Zentrum des Wärmeleitkörpers angeordnet sein. Das Zentrum kann insbesondere eine Fläche bzw. ein Raum um ein geometrisches Zentrum des Wärmeleitkörpers senkrecht zu der Haupterstreckungsebene sein. Alternativ kann der Wärmeleitkörper zum Zentrum versetzt angeordnet werden.

Die Anordnung in der Mitte hat den Vorteil, dass die Wärme gleichmäßig verteilt werden kann. Insbesondere verteilt sich somit die Wärme in entgegengesetzten Richtungen in der Haupterstreckungsebene gleich.

Eine Ausführungsform sieht vor, dass der Wärmeleitkörper in der Haupterstreckungsebene diskusförmig ausgebildet ist. Bevorzugt nimmt eine Höhe des Wärmeleitkörpers senkrecht zu der Haupterstreckungsebene von der Mitte weg abnimmt.

Insbesondere kann in dem Bereich der Elektronikvorrichtung die Höhe des Wärmeleitkörpers zunächst konstant sein und erst dann nach außen hin abnehmen. Der Wärmeleitkörper ist quasi nach außen verjüngend ausgebildet.

Die Form des Wärmeleitkörpers ist dadurch ideal für einen optimalen Wärmefluss in der Haupterstreckungsebene geformt. Dadurch kann die Wärme ist der Ebene gleichmäßig verteilt werden. Insbesondere kann sich ein abfallender Temperaturgradient senkrecht zu der Haupterstreckungsebene hin ausbilden, sodass die Wärme gleichmäßig über die gesamte Oberfläche der LC abstrahlen kann.

Eine Ausführungsform sieht vor, dass die Lokalspule eine Wärmeisolationsschicht aufweist, die den Wärmeleitkörper zumindest teilweise umschließt.

Insbesondere kann die Wärmeisolationsschicht ober- und/oder unterseitig an der LC ausgebildet sein. Beispielsweise kann der Wärmleitkörper vollständig in der Wärmeisolationsschicht ausgebildet sein, wobei die Wärmeisolationsschicht den Wärmeleitkörper vollständig umhüllt. Somit kann vorteilhaft gewährleistet werden, dass die Temperatur an der Oberfläche nicht über den vorgegebenen Temperaturgrenzwert ansteigt. Insbesondere kann die Wärmeisolationsschicht gleichmäßig dick ausgebildet sein. Vorzugsweise kann die Wärmeisolationsschicht gerade so dick sein, dass die Temperatur an der Oberfläche gleichmäßig verteilt ist und unterhalb des Temperaurgrenzwertes liegt.

Insbesondere ist die Wärmeisolationsschicht elektrisch nichtleitend und nicht magnetisierbar. Vorteilhafterweise hat die Wärmeisolationsschicht keinen Einfluss auf die MRT. Beispielsweise umfasst die Wärmeisolationsschicht einen Dämmstoff.

Eine Ausführungsform sieht vor, dass eine Dicke der Wärmeisolationsschicht senkrecht zu der Haupterstreckungsebene von der Mitte des Wärmeleitkörpers weg abnimmt.

Die Dicke ist folglich in einer senkrechten Richtung zu der Haupterstreckungsebene definiert. Besonders in der Mitte des Wärmeleitkörpers, in welcher sich die Elektronikvorrichtung vorzugsweise befinden kann, kann die Dicke der Wärmeisolationsschicht im Vergleich dicker ausgebildet sein. Dies hat den Vorteil, dass in dem Bereich, indem die Wärme gebildet wird, die Oberfläche der LC senkrecht zur Haupterstreckungsebene am Meisten abgeschirmt ist. Dadurch wird der Wärmefluss quasi entlang der Haupterstreckungsebene gelenkt und in dieser gleichmäßig verteilt. Besonders vorteilhaft kann somit eine gleichmäßige Temperaturverteilung an der Oberfläche der LC unterhalb des Temperaturgrenzwertes erreicht werden.

Eine Ausführungsform sieht vor, dass der Wärmeleitkörper unterhalb des Elektronikvorrichtung dicker ist als oberhalb der Elektronikvorrichtung. Insbesondere ist ein zur Unterseite gerichteter Anteil des Wärmeleitkörpers dicker als ein zur Oberseite gerichteter Anteil.

Vorzugsweise kann die Unterseite dafür vorgesehen sein, den Körper eines Menschen zu kontaktieren, wohingegen die Oberseite von Luft umgeben sein kann. Durch die, senkrecht zur Haupterstreckungsebene betrachtet, asymmetrische Verteilung des Wärmeleitkörpers kann somit gezielt die Wärme zu der Oberseite gelenkt werden, sodass die Wärme über die Oberfläche der Oberseite abstrahlen und/oder konvektiv in die Luft übergehen kann. Dies hat zudem den Vorteil, dass sich die Wärme an der Unterseite nicht staut und somit sich an der Oberfläche der Unterseite, die den Körper des Menschen kontaktieren kann, keine überhöhte Temperatur einstellen kann.

Vorzugsweise kann die Isolationsschicht an der Unterseite dicker sein, sodass ein Wärmefluss durch die Oberfläche an der Unterseite gegenüber der Oberseite reduziert ist. Dadurch kann ein Überhitzen der Unterseite unterbunden werden.

Eine Ausführungsform sieht vor, dass der Wärmeleitkörper ein Scharnier aufweist, das dazu ausgebildet ist, einen Winkel im Wärmeleitkörper anzupassen.

Die LC soll vorzugsweise so ausgebildet sein, sich einer Körperform des Menschen anpassen bzw. anschmiegen zu können, beispielsweise einen Rumpf, einem Arm, einem Kopf oder dergleichen. Dazu muss der Lokalspulenkörper flexibel ausgebildet sein, um in der Form anpassbar zu sein. Gerade durch einen starren Wärmeleitkörper kann diese Flexibilität mit zunehmender Größe des Wärmeleitkörpers reduziert werden. Um die Flexibilität der LC dennoch gewährleisten zu können, weist der Wärmeleitkörper das Scharnier bzw. zumindest ein Scharnier bzw. mehrere Scharniere auf.

Mittels des Scharniers kann der Winkel in der Haupterstreckungsebene im Wärmeleitkörper, und damit in der LC, angepasst bzw. eingestellt werden. Somit kann die LC vorteilhaft an den Körper des Menschen angepasst werden.

Eine Ausführungsform sieht vor, dass das Scharnier eine Rastvorrichtung aufweist, welches dazu ausgebildet ist, den Winkel festzustellen.

Insbesondere kann mittels der Rastvorrichtung das Scharnier in Stufen oder stufenlos eingerastet bzw. festgestellt werden. Dadurch kann vorteilhaft gewährleistet werden, dass eine Form der flexiblen LC fest eingestellt werden kann und sich somit während des Betriebes nicht verändert.

Eine Ausführungsform sieht vor, dass der Wärmeleitkörper verformbar ist. Insbesondere kann ein Material des Wärmeleitkörpers verformbar sein. Insbesondere kann der Wärmeleitkörper unter Normalbedingungen, d.h. bei Raumtemperatur, verformbar sein.

Unter verformbar kann verstanden werden, dass der Wärmeleitkörper gummiartig flexibel ist. Insbesondere kann der Wärmeleitkörper bis zu einer Grenze elastisch verformbar sein. Darüber hinaus kann der Wärmeleitkörper plastisch verformbar sein. Insbesondere kann der Wärmeleitkörper einen verformbaren Kunststoff aufweisen, beispielsweise eine Verbindung aus thermoplastischen Elastomeren (TPE).

Eine Ausführungsform sieht vor, dass der Lokalspulenkörper zumindest zwei beweglich miteinander verbundene Abschnitte aufweist. Insbesondere können eine Vielzahl von Abschnitten des Lokalspulenkörpers beweglich miteinander verbunden sein und im Wesentlichen in der Haupterstreckungsebene nebeneinander ausgebildet sein. Beispielsweise kann in jedem der Abschnitte jeweils eine Elektronikvorrichtung und/oder jeweils ein Wärmeleitkörper ausgebildet sein, sodass die LC zumindest zwei Elektronikvorrichtungen und/oder zumindest zwei Wärmeleitkörper umfassen kann.

Bevorzugt ist der Wärmeleitkörper über mehrere Abschnitte hinweg ausgebildet. Beispielsweise weist der Wärmeleitkörper hierzu die Scharniere auf und/oder ist verformbar ausgebildet, sodass sich eine Beweglichkeit zwischen den Abschnitten gewährleistet sein kann. Insbesondere kann ein Wärmeleitkörper die Wärme von mehreren, jeweils einem je Abschnitt, Elektronikvorrichtungen aufnehmen und in der Haupterstreckungsebene verteilen.

Eine Ausführungsform sieht vor, dass die Elektronikvorrichtung ein Gehäuse aufweist, wobei innerhalb des Gehäuses die Elektronikvorrichtung eine Leiterplatte mit einer elektronischen Komponente aufweist.

Insbesondere sind die elektronischen Komponenten auf der Leiterplatte in dem Gehäuse konzentriert, sodass eine magnetische Wechselwirkung mit dem MRT-System reduziert ist. Die elektronischen Komponenten, die beispielsweise den ADC, ICs, die Steuereinheit, die Recheneinheit, einen Energiespeicher oder dergleichen aufweisen. Innerhalb des Gehäuses kann Luft eingeschlossen sein, die die Wärme gleichmäßig im Gehäuse verteilt ist.

Das Gehäuse kann vorzugsweise aus einem wärmeleitenden, elektrisch nichtleitenden Material sein und dadurch besonders vorteilhaft die Wärme der Elektronikvorrichtung an den Wärmeleitkörper abgeben. Vorzugsweise kann das Gehäuse von dem Wärmeleitkörper zumindest teilweise oder vollständig umgeben sein. Mittels dem Gehäuse kann die Wärme somit vorteilhaft an den Wärmeleitkörper abgegeben werden.

Eine Ausführungsform sieht vor, dass das Gehäuse mit dem Wärmeleitkörper verklebt ist. Beispielsweise das Gehäuse auf dem Wärmeleitkörper mittels einer Klebschicht zwischen dem Gehäuse und dem Wärmeleitkörper aufgeklebt sein. Insbesondere kann eine solche Verbindung zwischen dem Gehäuse und einem starren Wärmeleitkörper vorteilhaft sein. Die Klebschicht kann insbesondere besonders wärmeleitend sein, wie beispielsweise eine Wärmeleitpaste. Dadurch kann vorteilhaft gewährleistet werden, dass der Wärmefluss von dem Gehäuse zum Wärmeleitkörper besonders effektiv ist.

Eine Ausführungsform sieht vor, dass das Gehäuse mit dem Wärmeleitkörper mittels einer Klemmverbindung verbunden ist.

Insbesondere kann das Gehäuse starr und der Wärmeleitkörper gummiartig flexibel sein, sodass eine Klebeverbindung keinen dauerhaften Halt bieten könnte. Insbesondere kann hierzu eine mechanische Verbindung in Ausbildung der Klemmverbindung vorteilhaft sein. Die Klemmverbindung umfasst insbesondere elektrisch nichtleitende Bauteile.

Beispielsweise kann die Klemmverbindung eine erste Platte und eine zweite Platte aufweisen. Zwischen der ersten Platte und der zweiten Platte kann sich der bewegliche, plattenartige Wärmeleitkörper befinden. Die Platten schließen quasi den Wärmeleitkörper sandwichartig, ober- und unterseitig, ein.

Die erste Platte kann mit dem Gehäuse fest verbunden, beispielsweise verschraubt, oder Teil des Gehäuses sein. Die zweite Platte kann beispielsweise über einen bzw. mehrere Abstandshalter mit der ersten Platte fest verbunden, beispielsweise verschraubt sein. Die Abstandshalter können insbesondere einen Abstand senkrecht zur Haupterstreckungsebene ausbilden, wobei innerhalb des Abstandes der Wärmeleitkörper eingeklemmt bzw. eingepresst sein kann. Eine solche Verbindung hat den Vorteil, dass selbst bei einem beweglichen Wärmeleitkörper eine feste und dauerhaft Verbindung gewährleistet sein kann.

Durch einen zweiten Aspekt der Erfindung ist ein Magnetresonanztomographiesystem (MRT-System) bereitgestellt. Das MRT-System umfasst zumindest die erfindungsgemäße Lokalspule.

In den Figuren zeigen:
- FIG 1: eine schematische Darstellung eines Ausschnittes einer erfindungsgemäßen Lokalspule gemäß einer bevorzugten Ausführungsform;
- FIG 2: eine schematische Darstellung eines Ausschnittes eines Wärmeleitkörpers mit einem Scharnier;
- FIG 3: eine schematische Darstellung eines Ausschnittes einer erfindungsgemäßen Lokalspule in einem geradwinkligen Zustand;
- FIG 4: eine schematische Darstellung eines Ausschnittes einer erfindungsgemäßen Lokalspule in einem abgewinkelten Zustand;
- FIG 5: eine schematische Darstellung eines Ausschnittes einer erfindungsgemäßen Lokalspule gemäß einer weiteren, bevorzugten Ausführungsform;
- FIG 6: eine schematische Darstellung eines Ausschnittes einer erfindungsgemäßen Lokalspule an einem Körper eines Menschen;
- FIG 7: eine schematische Darstellung eines erfindungsgemäßen Magnetresonanztomographiesystems gemäß einer beispielhaften Ausführungsform.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren ist die beschriebene Ausführungsform auch durch weitere der bereits beschriebenen Merkmale der Erfindung ergänzbar. In den Figuren bezeichnen gleiche Bezugszeichen jeweils funktionsgleiche Elemente.

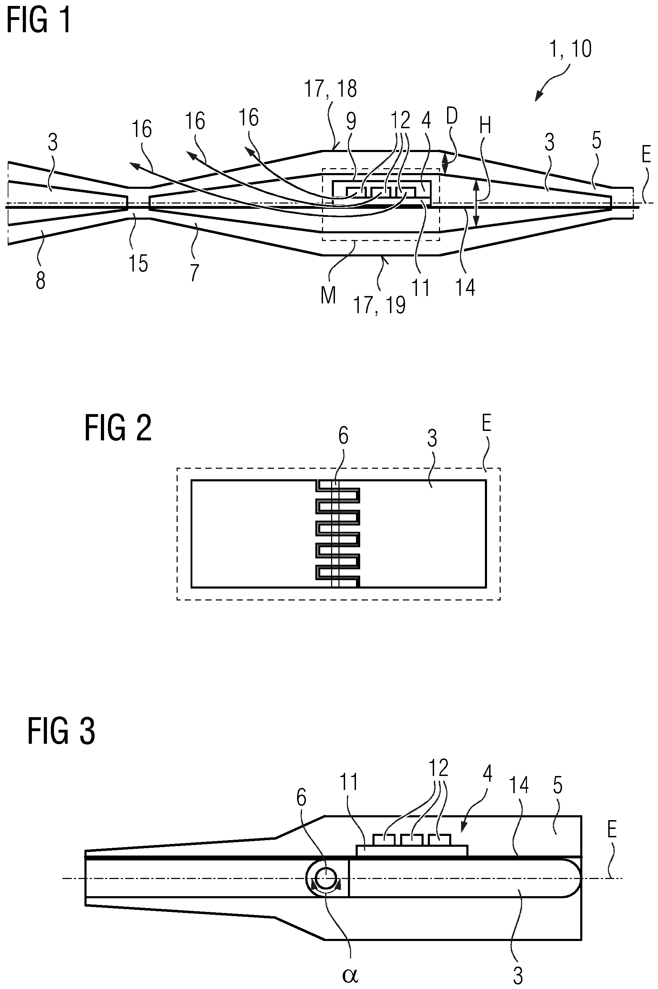

In FIG 1 ist eine schematische Darstellung eines Ausschnittes einer erfindungsgemäßen Lokalspule (LC) 1 gemäß einer bevorzugten Ausführungsform gezeigt. Die LC 1 weist einen plattenartigen Lokalspulenkörper 10 mit einer Haupterstreckungsebene E auf, sowie eine Elektronikvorrichtung 4 innerhalb des Lokalspulenkörpers 10. Erfindungsgemäß weist die LC 1 einen elektrisch nichtleitenden Wärmeleitkörper 3 auf, der wärmeleitend mit der Elektronikvorrichtung 4 verbunden und plattenartig innerhalb des Lokalspulenkörpers 10 ausbildet ist, um Wärme der Elektronikvorrichtung 4 in der Haupterstreckungsebene E des Lokalspulenkörpers 10 zu verteilen.

Die Elektronikvorrichtung 4 kann ein Gehäuse 9 aufweisen, welches eine Leiterplatte 11 sowie elektronische Komponenten 12 kompakt einschließt. Vorzugsweise ist die Elektronikvorrichtung 4, bzw. die elektronischen Komponenten 12 kompakt in einer Einheit verbaut, damit durch Störsignale von längeren digitalen Signal-/Bus-Leitungen zwischen den Komponenten 12 bzw. auf der Leiterplatte 11 der Magnetresonanz(MR)-Empfang der LC 1 nicht gestört wird.

Insbesondere kann die Elektronikvorrichtung 4 elektronische Komponenten 12 zur drahtlosen Verbindung mit einem MRT-System 2 aufweisen wie beispielsweise ein ADC, FPGAs und Transceiver ICs. Derartige Komponenten 12 benötigen im Vergleich zu drahtgebundenen LCs eine weit höhere Leistung, insbesondere um etwa einen Faktor 10, beispielsweise eine erhöhte Leistung von 0,5 Watt auf 5 Watt. Diese erhöhte Leistung wird größtenteils in Wärme umgesetzt werden, sodass eine Temperatur der Elektronikvorrichtung 4 in einem aktiven Betrieb ansteigt. Die Leiterplatte 11 kann insbesondere signaltechnisch mit einem Spulenabschnitt 14 der LC 1 verbunden sein, mittels welchem MR-Signale empfangen werden können. Das empfangene MR-Signal kann entsprechend von der Elektronikvorrichtung 4 verarbeitet und drahtlos an das MRT-System 2 gesendet werden. Insbesondere kann die LC 1 eine Vielzahl von Spulenabschnitten 14 aufweisen, die sich im Wesentlichen parallel zu der Haupterstreckungsebene E erstrecken.

Im gezeigten Beispiel ist die Elektronikvorrichtung 4, insbesondere das Gehäuse 9, von dem Wärmeleitkörper 3 vollständig umschlossen, sodass sich das Gehäuse 9 in einem Inneren des Wärmeleitkörpers 3 befindet. Das Gehäuse 9 ist insbesondere nicht magnetisch bzw. nicht magnetisierbar, jedoch aus einem wärmeleitenden Material. Das Gehäuse 9 ist vorzugsweise wärmeleitend mit dem Wärmeleitkörper 3 verbunden, sodass eine Wärmefluss 16 der erzeugten Wärme der Elektronikvorrichtung besonders günstig abgeführt werden kann. Das Gehäuse 9 kann beispielsweise mit dem Wärmeleitkörper 3 verklebt sein.

Der Wärmeleitkörper 3 ist insbesondere nicht magnetisch bzw. nicht magnetisierbar, um das MR-Signal nicht zu stören. Beispielsweise umfasst der Wärmeleitkörper 3 einen wärmeleitfähigen Kunststoff, vorzugsweise ohne metallische Partikel. Der Wärmeleitkörper 3 kann starr oder verformbar ausgebildet sein.

Der Wärmeleitkörper 3 kann in einem ersten, plattenartigen Abschnitt 7 der LC 1 plattenartig ausgebildet sein. In einem zweiten, plattenartigen Abschnitt 8 kann ein weiterer Wärmeleitkörper 3 ausgebildet sein, innerhalb welchem eine weitere Elektronikvorrichtung eingeschlossen sein kann. Der erste Abschnitt 7 und der zweite Abschnitt 8 können insbesondere über eine flexible Verbindung 15 beweglich miteinander verbunden sein, sodass sich die LC 1 flexibel auf einen menschlichen Körper anschmiegen lässt.

Insbesondere kann die Elektronikvorrichtung 4 in einer Mitte M des Wärmeleitkörpers angeordnet sein. Unter der Mitte M kann insbesondere ein mittiger Bereich in der Haupterstreckungsebene E verstanden werden. Somit kann sich der Wärmefluss 16 optimal in alle Richtungen in der Haupterstreckungsebene E ausbreiten.

Der Wärmeleitkörper 3 weist insbesondere eine Höhe H auf, welche sich senkrecht zur Haupterstreckungsebene E erstreckt. Die Höhe H ist hierbei wesentlich kleiner ausgebildet als Ausmaße des Wärmeleitkörpers 3 in der Haupterstreckungsebene E. Die Höhe H kann insbesondere in einem Verlauf entlang der Haupterstreckungsebene E veränderlich sein. Vorzugsweise nimmt die Höhe H von der Mitte M weg ab, sodass der Wärmeleitkörper 3 diskusartig ausgebildet sein kann. In der Mitte M, in der die Elektronikvorrichtung 4 ausgebildet sein kann, kann die Höhe H im Wesentlichen konstant sein.

Durch die spezielle Form des Wärmeleitkörpers 3 gemäß diesem Ausführungsbeispiel kann der Wärmefluss 16 besonders günstig in der Haupterstreckungsebene E verteilt werden. Die Pfeile, die den Wärmefluss 16 zeigen, sind hierbei lediglich schematisch dargestellt. Die Wärme kann hierbei über den gesamten Wärmeleitkörper 3 verteilt werden. Insbesondere kann der Wärmeleitkörper 3 in der Mitte M höher ausgebildet sein, damit ein größerer Wärmefluss 16 ermöglicht wird. Von der Mitte M weg wird die Höhe H immer kleiner, da auch der Wärmefluss 16 durch Entwärmung über eine Oberfläche 17 der LC 1 reduziert wird. Insbesondere kann die Wärme über die Oberfläche 17 abgestrahlt und/oder an die Umgebung abgegeben werden.

Durch die begünstigte, gleichmäßige Verteilung der Wärme in dem Wärmeleitkörper 3 kann eine Temperatur an der Oberfläche 17gleichmäßig verteilt sein. Insbesondere kann mittels der erfindungsgemäßen LC 1 erreicht werden, dass die Temperatur an der Oberfläche 17, insbesondere konzentriert an einem Temperatur-Hot-Spot in der Mitte M, nicht über einen vorgegebenen Temperaturgrenzwert tritt.

Der Effekt der gleichmäßigen Verteilung der Wärme kann insbesondere durch eine Wärmeisolationsschicht 5 der LC 1 unterstützt werden, die den Wärmeleitkörper 3 zumindest teilweise, insbesondere unter- und/oder oberseitig umschließt. Die Wärmeisolationsschicht 5 kann beispielsweise einen wärmeisolierenden Schaumstoff umfassen.

Vorzugsweise kann die Wärmeisolationsschicht 5 an der Mitte M ausgebildet sein, sodass der Wärmefluss entlang Haupterstreckungsebene begünstigt wird. Dadurch kann erreicht werden, dass die Temperatur in der Mitte M, also dort, wo die Wärme entsteht, an der Oberfläche unterhalb des Temperaturgrenzwertes bleibt.

Vorzugsweise kann die Wärmeisolationsschicht 5 den Wärmeleitkörper 3 vollständig umschließen. Insbesondere kann die Wärmeisolationsschicht 5 entlang der Haupterstreckungsebene E eine senkrecht zur Haupterstreckungsebene E veränderliche Dicke D aufweisen. Bevorzugt kann die Dicke D von der Mitte M des Wärmeleitkörpers 3 weg abnehmen, sodass der Effekt der Wärmeverteilung in der Haupterstreckungsebene E weiter begünstigt wird.

Beispielsweise kann eine Unterseite 18 der LC 1, insbesondere die Oberfläche 17 der Unterseite 18, dafür vorgesehen sein, im Betrieb den menschlichen Körper zu kontaktieren. Beispielsweise kann eine Oberseite 19 der LC 1, insbesondere die Oberfläche 17 der Oberseite 19, dafür vorgesehen sein, im Betrieb von Luft umgeben zu sein. Folglich kann es wünschenswert sein, dass der Wärmeleitkörper an der Oberseite 19 höher als an der Unterseite 18 ausgebildet ist, sodass die Wärme bevorzugt zur Oberseite 19 gelenkt wird. Somit wird die Wärme weg vom menschlichen Körper hin zur Umgebungsluft gelenkt, sodass sich die Wärme nicht am menschlichen Körper staut, sondern über die Umgebungsluft abgeführt werden kann. Dieser Effekt kann beispielsweise unterstützt werden, indem die Isolationsschicht 5 an der Unterseite 18 dicker als an der Oberseite 19 ausgebildet ist.

FIG 2 zeigt eine schematische Darstellung eines Ausschnittes des Wärmeleitkörpers 3 mit einem Scharnier 6. Mittels des Scharniers 6 kann beispielsweise ein Winkel α in der Haupterstreckungsebene E eingestellt werden. Eine Verstellachse des Scharniers 6 verläuft dementsprechend vorzugsweise in der Haupterstreckungsebene E. Das Scharnier 6 kann insbesondere aus demselben Material wie der Wärmeleitkörper 6 gebildet sein und somit begünstigt Wärme leiten.

In FIG 3 ist eine schematische Darstellung eines Ausschnittes der LC 1 gezeigt, wobei der Wärmeleitkörper 3 das Scharnier 6 in einem geradwinkligen Zustand zeigt. Der Winkel α kann hierbei genau oder in etwa 180° entsprechen. Beispielsweise kann der Winkel α über eine Rastvorrichtung (nicht gezeigt) festgestellt werden, insbesondere in Stufen oder stufenlos.

In dem gezeigten Beispiel kann die Elektronikvorrichtung 4 auf dem Wärmeleitkörper 3 angeordnet sein. Beispielsweise kann die Elektronikvorrichtung 4 von der Wärmeisolationsschicht 5 umschlossen sein, sodass die Wärme lediglich einseitig von der Elektronikvorrichtung 4 in den Wärmeleitkörper 3 gelenkt geführt wird.

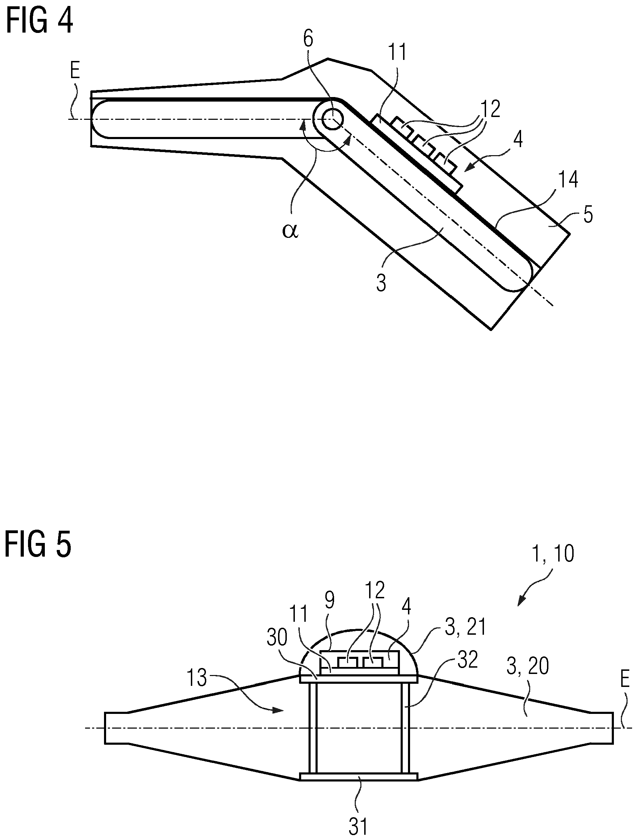

FIG 4 zeigt eine schematische Darstellung eines Ausschnittes der LC 1, wobei der Wärmeleitkörper 3 das Scharnier 6 in einem abgewinkelten Zustand zeigt. Beispielsweise entspricht der Winkel α einem Winkel von etwa 140°, sodass die LC 1 beispielsweise an einen Rumpf oder dergleichen angelegt werden kann.

In FIG 5 ist eine schematische Darstellung eines der LC 1 gezeigt, wobei hierbei ein Wärmeleitkörper 3, umfassend einen beweglichen Kunststoff 20 und ein Wärmeleitkörper 3, umfassend einem starren Kunststoff 21. Unter dem beweglichen Kunststoff 20 kann insbesondere ein gummiartig flexibler Kunstostoff verstanden werden, und/oder ein elastisch und/oder plastisch verformbarer Kunststoff, beispielsweise eine Verbindung aus thermoplastischen Elastomeren (TPE). Im gezeigten Beispiel umschließt der starre Kunststoff 21 das Gehäuse 9 der Elektronikvorrichtung 4. Zur Verbindung des starren Kunststoffes 21 mit dem beweglichen Kunststoff 20 kann eine Klemmverbindung 13 vorgesehen sein.

Die Klemmverbindung 13 kann eine erste Platte 30 und eine zweite Platte 31 aufweisen. Zwischen der ersten Platte 30 und der zweiten Platte 31 kann sich beispielsweise der bewegliche, plattenartige Wärmeleitkörper 3, 20 befinden. Die Platten 30, 31 schließen quasi den Wärmeleitkörper 3, 20 sandwichartig, ober- und unterseitig, ein.

Die erste Platte 30 kann mit dem starren Kunststoff 21 fest verbunden, beispielsweise verklebt oder verschraubt sein. Die zweite Platte 31 kann beispielsweise über einen bzw. mehrere Abstandshalter 32 mit der ersten Platte 30 fest verbunden, beispielsweise verschraubt sein. Die Abstandshalter 32 können insbesondere einen Abstand senkrecht zur Haupterstreckungsebene E ausbilden, wobei innerhalb des Abstandes der Wärmeleitkörper 3, 20 eingeklemmt bzw. eingepresst sein kann. Eine solche Verbindung hat den Vorteil, dass selbst bei einem beweglichen Wärmeleitkörper 3, 20 eine feste und dauerhaft Verbindung gewährleistet sein kann.

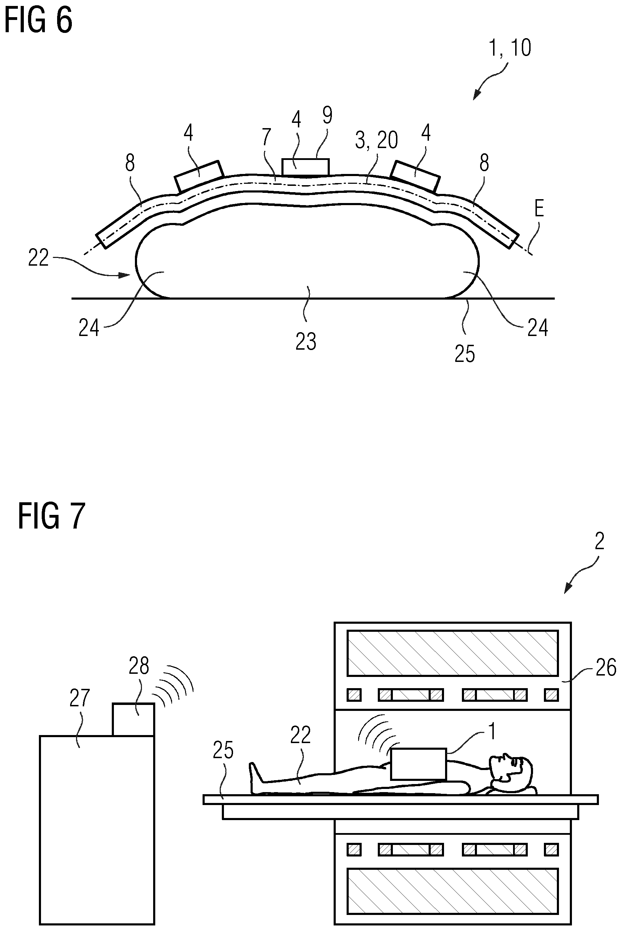

In FIG 6 ist eine schematische Darstellung eines Ausschnittes LC 1 an einem Körper eines Patienten 22. Beispielsweise liegt die LC 1 an einem Rumpf 23 und an zwei Armen 24 des Patienten 22 an, wobei der Patient 22 auf einer Patientenliege 25 liegt. Der Wärmeleitkörper 3 aus beweglichem Kunststoff 20 kann sich hierbei entlang der Haupterstreckungsebene E und über mehrere Abschnitte 7, 8 des Lokalspulenkörpers 10 der LC 1 erstrecken. Der Lokalspulenkörper 10 kann beispielsweise aufgrund des beweglichen Wärmeleitkörpers 3, 20 dazu ausgebildet sein, sich an den Patienten 22 anzuschmiegen.

Beispielsweise weist jeder der Abschnitte 7, 8 eine Elektronikvorrichtung 4 mit einem Gehäuse 9 auf, die beispielsweise mittels der Klemmvorrichtung 13 (nicht gezeigt) mit dem Wärmeleitkörper 3, 20 verbunden sind.

FIG 7 zeigt eine schematische Darstellung eines erfindungsgemäßen MRT-Systems 2 gemäß einer beispielhaften Ausführungsform. Das MRT-System 2 kann die erfindungsgemäße LC 1 aufweisen. Darüber hinaus kann das MRT-System 2 eine Magneteinheit 26, sowie eine Steuereinrichtung 27 mit einem Sende- und Empfangsmodul 28 aufweisen.

In einem Patiententunnel 29 der Magneteinheit 26 liegt beispielsweise der Patient 22 auf der Patientenliege 25, wobei auf dem Rumpf des Patienten 22 die LC 1 liegt. Die LC 1 kann insbesondere keine Verbindungskabel mit LC-externen Geräte aufweisen. Die LC 1 kann insbesondere über eine drahtlose Verbindung mit der Steuereinrichtung 27, insbesondere mit dem Sende- und Empfangsmodul 28 verbunden sein, worüber Bild- und/oder Steuersignale übertragen werden können. Eine drahtlose LC 1 benötigt eine um ein Vielfaches höhere Leistung als eine drahtgebundene LC, sodass die in Wärme umgewandelte Leistung durch den erfindungsgemäßen Wärmeleitkörper 3 verteilt wird.

Insgesamt zeigt die Erfindung eine Möglichkeit zur Wärmeabführung für drahtlose (engl. wireless) MRT-Lokalspulen.

## Patentansprüche

1. Lokalspule (1) für ein Magnetresonanztomographiesystem (2), aufweisend
einen plattenartigen Lokalspulenkörper (10) mit einer Haupterstreckungsebene (E), und
eine Elektronikvorrichtung (4) innerhalb des Lokalspulenkörpers (10),
**gekennzeichnet durch**
- einen elektrisch nichtleitenden Wärmeleitkörper (3), der wärmeleitend mit der Elektronikvorrichtung (4) verbunden und plattenartig innerhalb des Lokalspulenkörpers (10) ausbildet ist, um Wärme der Elektronikvorrichtung (4) in der Haupterstreckungsebene (E) des Lokalspulenkörpers (10) zu verteilen.

2. Lokalspule (1) nach Anspruch 1, **dadurch gekennzeichnet, dass** die Elektronikvorrichtung (4) von dem Wärmeleitkörper (3) umschlossen ist.

3. Lokalspule (1) nach Anspruch 1 oder 2, **dadurch gekennzeichnet, dass** die Elektronikvorrichtung (4), in der Haupterstreckungsebene (E) betrachtet, in einer Mitte (M) des Wärmeleitkörpers (3) angeordnet ist.

4. Lokalspule (1) nach Anspruch 3, **dadurch gekennzeichnet, dass** eine Höhe (H) des Wärmeleitkörpers (3) senkrecht zu der Haupterstreckungsebene (E) von der Mitte (M) weg abnimmt, wobei insbesondere der Wärmeleitkörper (3) in der Haupterstreckungsebene (E) diskusförmig ausgebildet ist.

5. Lokalspule (1) nach einem der vorherigen Ansprüche, **gekennzeichnet durch** eine Wärmeisolationsschicht (5), die den Wärmeleitkörper (3) zumindest teilweise umschließt.

6. Lokalspule (1) nach Anspruch 3 oder 4 und Anspruch 5, **dadurch gekennzeichnet, dass** eine Dicke (D) der Wärmeisolationsschicht (5) senkrecht zu der Haupterstreckungsebene (E) von der Mitte (M) des Wärmeleitkörpers (3) weg abnimmt.

7. Lokalspule (1) nach einem der vorherigen Ansprüche, **dadurch gekennzeichnet, dass** der Wärmeleitkörper (3) unterhalb des Elektronikvorrichtung (4) dicker ist als oberhalb der Elektronikvorrichtung (4).

8. Lokalspule (1) nach einem der vorherigen Ansprüche, **dadurch gekennzeichnet, dass** der Wärmeleitkörper (3) ein Scharnier (6) aufweist, das dazu ausgebildet ist, einen Winkel (α) im Wärmeleitkörper (3) anzupassen.

9. Lokalspule (1) nach Anspruch 8, **dadurch gekennzeichnet, dass** das Scharnier (6) eine Rastvorrichtung aufweist, welches dazu ausgebildet ist, den Winkel (α) festzustellen.

10. Lokalspule (1) nach einem der Ansprüche 1 bis 7, **dadurch gekennzeichnet, dass** der Wärmeleitkörper (3) verformbar ist.

11. Lokalspule (1) nach einem der Ansprüche 8 bis 10, **dadurch gekennzeichnet, dass** der Lokalspulenkörper (10) zumindest zwei beweglich miteinander verbundene Abschnitte (7, 8) aufweist, wobei der Wärmeleitkörper (3) über die zumindest zwei Abschnitte (7, 8) hinweg ausgebildet ist.

12. Lokalspule (1) nach einem der vorherigen Ansprüche, **dadurch gekennzeichnet, dass** die Elektronikvorrichtung (4) ein Gehäuse (9) aufweist, wobei innerhalb des Gehäuses (9) die Elektronikvorrichtung (4) eine Leiterplatte (11) mit einer elektronischen Komponente (12) aufweist.

13. Lokalspule (1) nach Anspruch 12, **dadurch gekennzeichnet, dass** das Gehäuse (9) mit dem Wärmeleitkörper (3) verklebt ist.

14. Lokalspule (1) nach Anspruch 12 oder 13, **dadurch gekennzeichnet, dass** das Gehäuse (9) mit dem Wärmeleitkörper (3) mittels einer Klemmverbindung (13) verbunden ist.

15. Magnetresonanztomographiesystem (2), umfassend eine Lokalspule (1) nach einem der vorherigen Ansprüche.

## Claims

1. Local coil (1) for a magnetic resonance tomography system (2), having
a plate-shaped local coil body (10) with a main extension plane (E), and
an electronic apparatus (4) within the local coil body (10),
**characterised by**
- an electrically non-conducting heat sink body (3), which is linked for conduction of heat to the electronic apparatus (4) and is embodied as a type of plate within the local coil body (10), in order to distribute heat of the electronic apparatus (4) in the main extension plane (E) of the local coil body (10).

2. Local coil (1) according to claim 1, **characterised in that** the electronic apparatus (4) is enclosed by the heat sink body (3).

3. Local coil (1) according to claim 1 or 2, **characterised in that** the electronic apparatus (4), viewed in the main extension plane (E), is arranged in the middle (M) of the heat sink body (3).

4. Local coil (1) according to claim 3, **characterised in that** a height (H) of the heat sink body (3) at right angles to the main extension plane (E) reduces from the middle (M) outwards, wherein in particular the heat sink body (3) is embodied in a disc shape in the main extension plane (E).

5. Local coil (1) according to one of the preceding claims, **characterised by** a heat insulation layer (5), which at least partly encloses the heat sink body (3).

6. Local coil (1) according to claim 3 or 4 and claim 5, **characterised in that** a thickness (D) of the heat insulation layer (5) at right angles to the main extension plane (E) reduces from the middle (M) of the heat sink body (3) outwards.

7. Local coil (1) according to one of the preceding claims, **characterised in that** the heat sink body (3) is thicker below the electronic apparatus (4) than it is above the electronic apparatus (4).

8. Local coil (1) according to one of the preceding claims, **characterised in that** the heat sink body (3) has a hinge (6), which is embodied to adjust an angle (α) in the heat sink body (3).

9. Local coil (1) according to claim 8, **characterised in that** the hinge (6) has a latching apparatus, which is embodied to fix the angle (α).

10. Local coil (1) according to one of claims 1 to 7, **characterised in that** the heat sink body (3) is deformable.

11. Local coil (1) according to one of claims 8 to 10, **characterised in that** the local coil body (10) has at least two sections (7, 8) connected movably to one another, wherein the heat sink body (3) is embodied extending over the at least two sections (7, 8).

12. Local coil (1) according to one of the preceding claims, **characterised in that** the electronic apparatus (4) has a housing (9), wherein within the housing (9) the electronic apparatus (4) has a circuit board (11) with an electronic component (12).

13. Local coil (1) according to claim 12, **characterised in that** the housing (9) is glued to the heat sink body (3).

14. Local coil (1) according to claim 12 or 13, **characterised in that** the housing (9) is connected to the heat sink body (3) by means of a clamp connection (13).

15. Magnetic resonance tomography system (2), comprising a local coil (1) according to one of the preceding claims.

## Revendications

1. Bobine (1) locale d'un système (2) de tomodensitométrie par résonnance magnétique, comportant
un corps (10) de bobine locale de type en plaque ayant un plan (E) d'étendue principale, et
un dispositif (4) électronique à l'intérieur du corps (10) de la bobine locale,
**caractérisée par**
- un corps (3) conducteur de la chaleur, mais non conducteur de l'électricité, qui est relié d'une manière conductrice de la chaleur au dispositif (4) électronique et qui est constitué en étant de type en plaque dans le corps (10) de la bobine locale, afin de répartir de la chaleur du dispositif (4) électronique dans le plan (E) d'étendue principale du corps (10) de la bobine locale.

2. Bobine (1) locale suivant la revendication 1, **caractérisée en ce que** le dispositif (4) électronique est enfermé par le corps (3) conducteur de la chaleur.

3. Bobine (1) locale suivant la revendication 1 ou 2, **caractérisée en ce que** le dispositif (4) électronique est, considéré dans le plan (E) d'étendue principale, disposé au milieu (M) du corps (3) conducteur de la chaleur.

4. Bobine (1) locale suivant la revendication 3, **caractérisée en ce qu'**une hauteur (H) du corps (3) conducteur de la chaleur perpendiculairement au plan (E) d'étendue principale diminue en s'éloignant du milieu (M), dans lequel en particulier, le corps (3) conducteur de la chaleur est constitué en forme de disque dans le plan (E) d'étendue principale.

5. Bobine (1) locale suivant l'une des revendications précédentes, **caractérisée par** une couche (5) d'isolation vis-à-vis de la chaleur, qui enferme au moins en partie le corps (3) conducteur de la chaleur.

6. Bobine (1) locale suivant la revendication 3 ou 4 et la revendication 5, **caractérisée en ce qu'**une épaisseur (D) de la couche (5) d'isolation vis-à-vis de la chaleur perpendiculairement au plan (E) d'étendue principale diminue en s'éloignant du milieu (M) du corps (3) conducteur de la chaleur.

7. Bobine (1) locale suivant l'une des revendications précédentes, **caractérisée en ce que** le corps (3) conducteur de la chaleur est plus épais en-dessous du dispositif (4) électronique qu'au-dessus du dispositif (4) électronique.

8. Bobine (1) locale suivant l'une des revendications précédentes, **caractérisée en ce que** le corps (3) conducteur de la chaleur comporte une charnière (6), qui est constituée pour adapter un angle (α) dans le corps (3) conducteur de la chaleur.

9. Bobine (1) locale suivant la revendication 8, **caractérisée en ce que** la charnière (6) a un dispositif d'encliquetage, qui est constitué pour déterminer l'angle (α).

10. Bobine (1) locale suivant l'une des revendications 1 à 7, **caractérisée en ce que** le corps (3) conducteur de la chaleur est déformable.

11. Bobine (1) locale suivant l'une des revendications 8 à 10, **caractérisée en ce que** le corps (10) de la bobine locale a au moins deux parties (7, 8) assemblées entre elles de manière amovible, dans laquelle le corps (3) conducteur de la chaleur est formé au-delà des au moins deux parties (7, 8).

12. Bobine (1) locale suivant l'une des revendications précédentes, **caractérisée en ce que** le dispositif (4) électronique a un boîtier (9), dans laquelle, à l'intérieur du boîtier (9), le dispositif (4) électronique a une plaquette (11) à circuit imprimé ayant un composant (12) électronique.

13. Bobine (1) locale suivant la revendication 12, **caractérisée en ce que** le boîtier (9) est collé au corps (3) conducteur de la chaleur.

14. Bobine (1) locale suivant la revendication 12 ou 13, **caractérisée en ce que** le boîtier (9) est assemblé au corps (3) conducteur de la chaleur au moyen d'un assemblage (13) par serrage.

15. Système (2) de tomodensitométrie par résonnance magnétique, comprenant une bobine (1) locale suivant l'une des revendications précédentes.
